# EUROPEAN PATENT APPLICATION

(11) **EP 1 930 754 A1**
(43) Date of publication of application: **11.06.2008**
(21) Application number: 06767041.4
(22) Date of filing: 21.06.2006
(51) Int. Cl.: G02B 6/122, G02B 6/42

(54) **OPTICAL WAVEGUIDE DEVICE**

(30) Priority: 27.09.2005 JP 2005279988
(71) Applicant: Mitsumi Electric Co., Ltd., Tama-shi, Tokyo 206-8567 (JP)
(72) Inventor: ISHIKAWA, Yoshihiro, Tama-shi Tokyo 2068567 (JP); ITAGAKI, Youichi, Tama-shi, Tokyo 2068567 (JP)
(74) Representative: Grünecker, Kinkeldey, Stockmair & Schwanhäusser Anwaltssozietät
(86) International application number: PCT/JP2006/312382
(87) International publication number: WO 2007/037051

(57) **Abstract**

To provide a wiring technique which can easily realize the high speed communication between apparatuses and the conventional electrical communication at a low cost. The optic cable constituted of the core unit 12 and the clad unit 13 is extended on the film substrate 11, the photoelectric conversion element 15 which optically couples with the core unit 12 is provided, and the metal wiring 14 which is electrically connected to the photoelectric conversion element 15 is extended toward the ends of the light guide direction.

## Description

### Technical Field

The present invention relates to an optical waveguide device which transmits an electrical communication in high speed.

### Background Art

Recently, the CPU (Central Processing Unit) and the like are being developed in various data process apparatuses including a wide range from the backbone server of the network to the PC (personal Computer) of each household and the like, and the arithmetic processing is becoming high speed and the capacity of the data to be handled is becoming larger.

Therefore, when the high speed communication such as data transmission and the like in the substrate in the apparatus and the like is needed, there is a data process apparatus which carries out the high speed communication such as a data transmission by an optical communication which can carry out the broad band communication at a low loss instead of a communication by a conventional metallic cable.

For example, a non-patent document 1 discloses a technique relating to an optical waveguide film in which a 45-degree mirror is provided at the end portion of the core and which guides the light entering from the mirror in the extending direction of the core and a technique relating to a module in which the optical waveguide film is disposed at the position where the light enters in the core from the VCSEL element which is the photoelectric conversion element provided on the substrate. In the technique of the non-patent document 1, the communication between the substrates can be carried out by the optical communication by the optical waveguide film which is the optical wiring.
Non-patent document 1 : Shigemi Ohtsu, Keiji Shimizu, Kazutoshi Tanita, Eiichi Akutsu, "VCSEL module using high polymer waveguide", The Institute of Electronics, Information and Communication Engineers, Electronics Society 2004, 2004, pg. 149

### Disclosure of the Invention

### Problem to be solved by the Invention

However, when a high speed communication is carried out between the substrates by using the optical communication, the assembly such as the positioning of the PD, the VCSEL and the film waveguide at the time when the substrates are connected is complicated and the cost is expensive in the structure disclosed in the non-patent document 1 which is the above described conventional technique.

In view of the above mentioned problem of the conventional technique, the present invention provides a technique which easily realizes the high speed data communication between the substrates using the optical communication at low cost.

### Means for solving the problem

In order to solve the above problem, according to the present invention, in an optical waveguide device an optic cable which is constituted of a clad unit and a core unit provided therein extends on a film substrate in a light guide direction, a photoelectric conversion element which optically couples with the core unit is mounted on the film substrate, and a metal wiring which is electrically connected to the photoelectric conversion element extends toward ends of the light guide direction of the film substrate.

Preferably, the photoelectric conversion element is mounted on a surface of the film substrate which is same side as a surface in which the optic cable is extended on the film substrate.

Preferably, the photoelectric conversion element is mounted on a surface of the film substrate which is opposite side of a surface in which the optic cable is extended on the film substrate and the optic cable and the core unit are optically coupled via the film substrate.

Preferably, the metal wiring is extended on the surface of the film substrate which is same side as the surface in which the optic cable is extended on the film substrate.

Preferably, the metal wiring is extended on the surface of the film substrate which is opposite side of the surface in which the optic cable is extended on the film substrate.

Preferably, an end mirror which reflects a light in a traversing direction of the light guide direction of the core unit is formed at an optical coupling portion in which the core unit couples with the photoelectric conversion element.

Preferably, the end mirror is formed on an end surface of the core unit so as to incline with respect to a cross-sectional surface of the light guide direction and is an inclining surface which is exposed outside of the clad unit.

Preferably, the photoelectric conversion element and the metal wiring are provided at each end of the light guide direction of the film substrate.

Preferably, the photoelectric conversion element at one end of the light guide direction of the film substrate is a light emitting element and the photoelectric conversion element at the other end is a light receiving element.

Preferably, the core unit is branched via a branching circuit, the photoelectric conversion elements are optically coupled with each of the branched core units, and the metal wiring is applied to each of the photoelectric conversion elements.

Preferably, the metal wiring which extends across between both ends of the light guide direction of the film substrate is provided on an outside surface of the film substrate and/or an outside surface of the clad unit.

Preferably, the optic cable is formed in a film form.

Preferably, the photoelectric conversion element is mounted by a flip-chip connection.

### Effect of the Invention

According to the present invention, the optical waveguide device has an optic cable which is constituted of a clad unit and a core unit provided therein extended on a film substrate in a light guide direction, has the photoelectric conversion element electrically coupled with the core unit mounted thereon and the metal wiring which is electrically connected to the photoelectric conversion element extended toward the end of the light guide direction of the film substrate. Therefore, the connection of the end part of the optical waveguide device and the apparatus can be the electrical connection via the conventional connector or the like, and the assembly is easy because there is no need to carry out an alignment between the photoelectric conversion element and the optic cable. Therefore, the communication can be carried out at low cost.

### Brief Description of the Drawings

[FIG. 1A] This is a perspective view showing an outside appearance of one end side of an optical waveguide device 100 which is the present invention.
[FIG. 1B] This is a perspective view of a region A in the optical waveguide device 100.
[FIG. 2A] This is a cross sectional view cut along in a direction of Y1-Y2 of a photoelectric conversion element 15 of the optical waveguide device 100.
[FIG. 2B] This is a cross sectional view cut along in the direction of Y1-Y2 of the photoelectric conversion element 15 of the optical waveguide device 100.
[FIG. 3] This is an outer perspective view exemplifying a connection between substrates by the optical waveguide device 100.
[FIG. 4] This is a perspective view exemplifying the optical waveguide device 101 which is a modification example.
[FIG. 5A] This is a cross sectional view cut along in the direction of Y1-Y2 of the photoelectric conversion element 15.
[FIG. 5B] This is a cross sectional view cut along in the direction of Y1-Y2 of the photoelectric conversion element 15. Best Mode for Carrying out the Invention

Hereinafter, the embodiment of the present invention will be described in detail with reference to the drawings. However, the invention is not limited to the embodiment. Further, the embodiment of the invention shows the best mode of the invention, and the terminology and the usage of the invention is not limited to this.

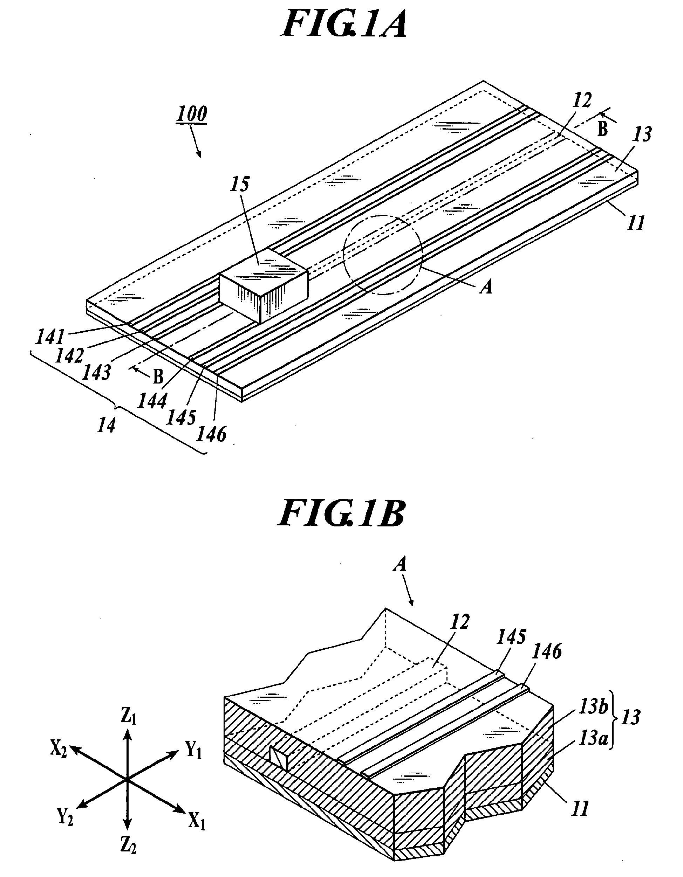

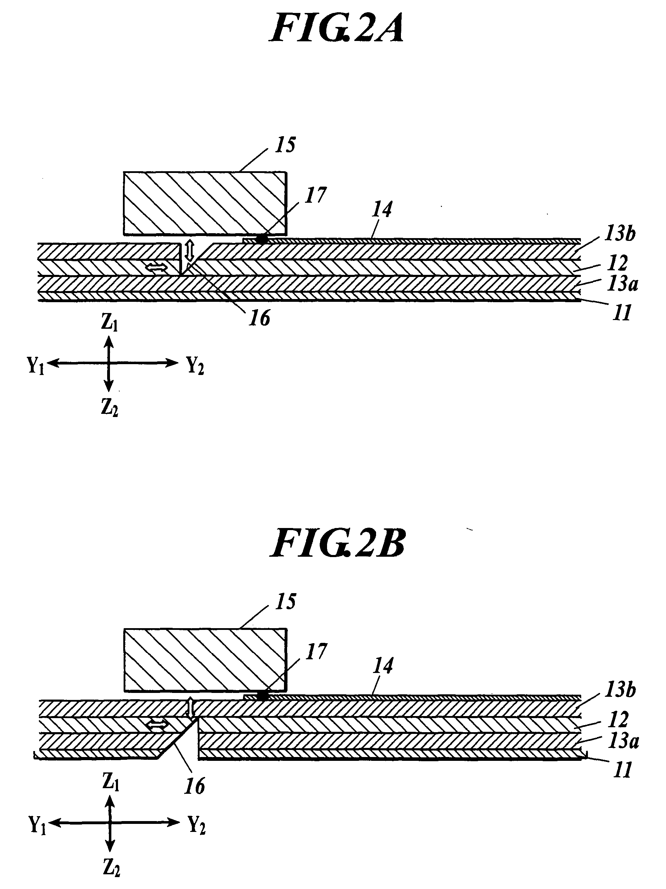

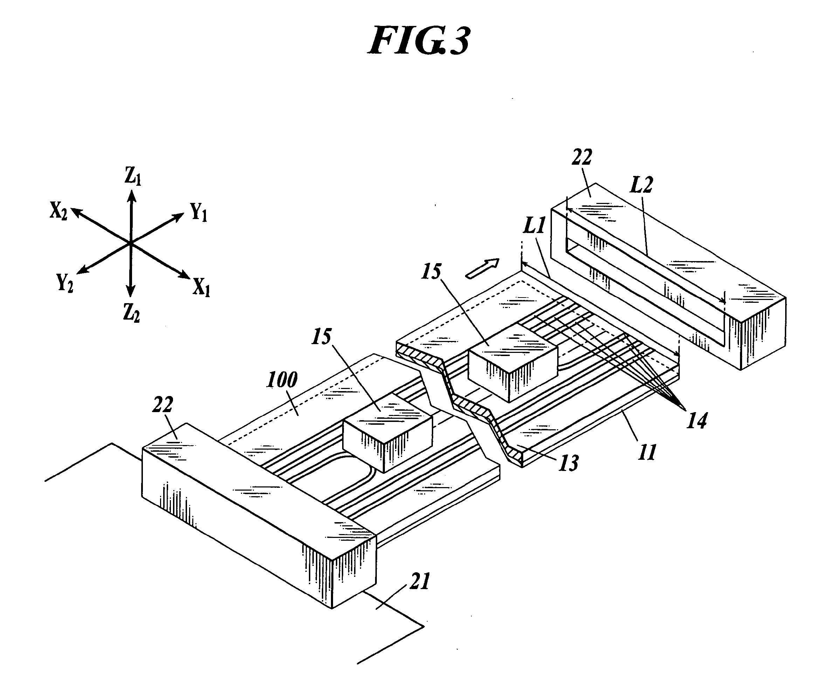

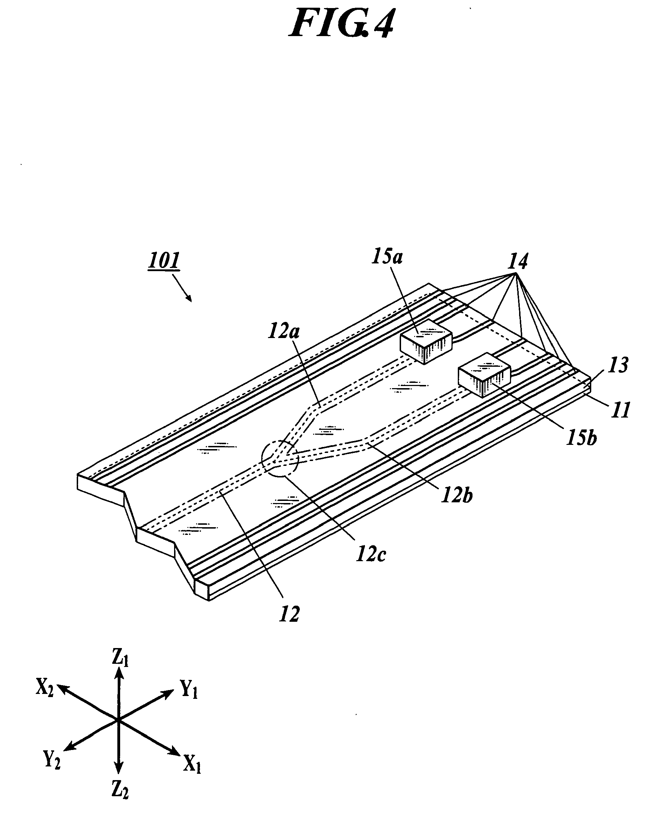

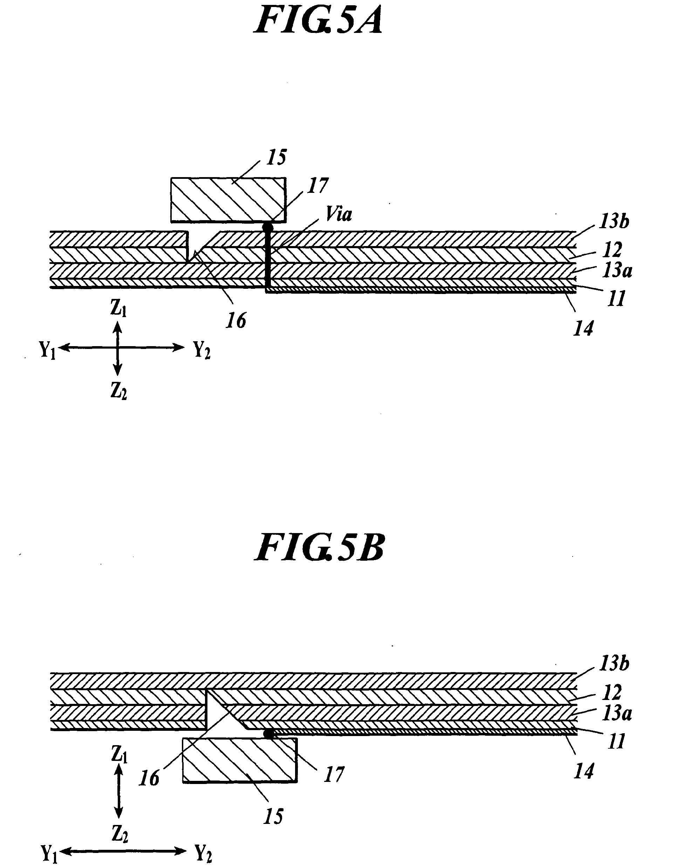

FIG. 1A is a perspective view showing an outside appearance of one end side of an optical waveguide device 100 which is the present invention, FIG. 1B is a perspective view of a region A in the optical waveguide device 100, FIG. 2A is a cross sectional view cut along in a direction of Y1-Y2 of the optical waveguide device 100, FIG. 2B is a cross sectional view cut along in the direction of Y1-Y2 of the optical waveguide device 100, FIG. 3 is a diagram exemplifying the connection between substrates by the optical waveguide device 100, FIG. 4 is a perspective view exemplifying a structure of the optical waveguide device 100 which comprises the VCSEL 15a and the PD 15b, FIG. 5A is a cross sectional view cut along in the direction of Y1-Y2 of the optical waveguide device 100, and FIG. 5B is a cross sectional view cut along in the direction of Y1-Y2 of the optical waveguide device 100.

As shown in FIGS. 1A and 1B, the optical waveguide device 100 is constituted of a film substrate 11, a core unit 12, a clad unit 13, a metallic wiring 14 and a photoelectric conversion element 15. Here, the structure of the other end side is omitted because the structure is symmetry with respect to the extending direction of the optical waveguide device 100.

The film substrate 11 is a resin film of the PI (polymide), the PET (polyethylene terephtalate), the PEN (polyethylene naphthalate) or the like, for example. The core unit 12 and the clad unit 13 are constituted of a polymer resin material having an optical transparency, and, for example, are made of the epoxy type resin, the acrylic resin, the imide system resin and the like. The polymer resin material having heat resistance at the time of reflow of the solder bump is preferred, and the material having low thermal expansion coefficient is more preferred.

As shown in FIG. 1B, the core unit 12 is formed on the lower clad unit 13a which is laminated on the surface in the Z1 direction which is one surface of the film substrate 11 in the extending direction (direction of Y1-Y2 in the example shown in the drawing) of the optical waveguide device 100 which is the light guide direction, and the upper clad unit 13b is laminated thereon so as to cover the core unit 12. That is, the core unit 12 is buried in the clad unit 13 by the lower clad unit 13a and the upper clad unit 13b. The refraction factor of light in the core unit 12 is higher than the refraction factor of light in the clad unit 13, and is also higher than the refraction factor of light in air. Therefore, the light propagates while totally reflecting in the extending direction of the optical waveguide device 100 in the core unit 12.

Forming of the core unit 12 and the clad unit 13 on one surface of the film substrate 11 is carried out by the film laminate method in which the core film is laminated after the lamination of the lower clad unit 13a on one surface of the film substrate 11, the core unit 12 is formed by the phenomenon which occurs after the ultraviolet irradiation by the photolithography in the pattern masking, and the upper clad unit 13b is laminated. Alternatively, a method which laminates the lower clad unit 13a on one surface of the film substrate 11 and laminates the resin layer in which the component is adjusted to the same refraction factor as the core on the lower clad unit 13a by the spin coat method, forms the pattern of the core unit 12 on the resin layer by the photolithography using the pattern mask, carries out the dry etching process until the lower clad unit 13a is exposed leaving the pattern of the formed core unit 12 by the RIE (Reactive Ion Etching) apparatus or the like, and carries out the spin coating to the upper clad unit 13b and laminates the upper clad unit 13b or the like.

The metal wiring 14 is an electric wiring which is coated on the clad unit 13 by Au, Cu, Ag, Al or the like by the vacuum coating method such as the vacuum deposition method, the sputtering method or the like using the pattern masking, the electrolytic plating process, the electroless plating process, the silver paste or the like. The metal wiring 14 is formed in the extending direction (direction of Y2-Y1 in the example shown in the drawing) of the optical waveguide device 100, and is constituted of the metal wirings 141, 142, 145 and 146 which connect the proximity of one end of the optical waveguide device 100 and the proximity of the other end of the optical waveguide device 100 (both ends of the optical waveguide device 100 in the direction of Y2-Y1 in the example shown in the drawing) and the metal wirings 143 and 144 which transmits the electric signal to the photoelectric conversion element 15.

The photoelectric conversion element 15 is the VCSEL, the PD or the like provided near the end in the near side of the extending direction of the optical waveguide device 100, and is an element which converts the emission of the light according to the electric signal supplied from outside and the received light into the electric signal. As shown in FIGS. 2A and 2B, the photoelectric conversion element 15 faces the surface in which the light is emitted/received in the film direction (direction of Z2 in the example shown in the drawing), and is mounted on the metal wiring 14 formed on the clad unit 13 by the flip-ship mounting using the solder bump 17.

On the film surface opposite to the surface in which the light is emitted/received of the photoelectric conversion element 15, an end mirror 16 which reflects the light from the photoelectric conversion element 15 in the direction (direction of Y1 in the example shown in the drawing) of propagating the light inside the core unit 12 or which reflects the light which propagates the core unit 12 to the photoelectric conversion element 15 is formed as shown in FIG. 2A. Particularly, the end mirror 16 is a 45-degree mirror with respect to the core unit 12.

The forming of the end mirror 16 is carried out by the processing by the dicing saw, the laser machining device or the like or by the dissolution treatment by the liquid phase etching or the vapor phase etching process after the core unit 12 and the clad unit 13 are formed. Here, the coating may be carried out to the formed reflecting surface at the time of forming of the above mentioned metal wiring 14. Further, the forming of the end mirror 16 may be structures so as to form the end mirror 16 on the surface which is opposite of the photoelectric conversion element 15 as shown in FIG. 2B and not only in a structure in which the end mirror 16 is formed on the surface which has the photoelectric conversion element 15 as shown in FIG. 2A.

The optical waveguide device 100 and the substrate 21 are connected by inserting the end part of the optical waveguide device 100 including the metal wiring 14 in the connection connector 22 which has the metal terminal connected to the circuit of the substrate 21 inside thereof as shown in FIG. 3. Here, the width L2 of the insertion opening of the connection connector 22 and the width L1 of the end part of the optical waveguide device 100 including the metal wiring 14 are formed so as to be approximately in the same size, the width L1 not being larger than the width L2, and the play width is adjusted in advance to the extent that the connection of the metal terminal in the connection connector 22 and the metal wiring 14 do not drift when the optical waveguide device 100 is attached.

The description in the embodiment only shows an example of the present invention, and the present invention is not limited to this. The detail structure of the optical waveguide device 100 of the present invention can be arbitrarily changed within the scope of the present invention.

For example, as for a modification example of the optical waveguide device 100, there is the optical waveguide device 101 as shown in FIG. 4. In the optical waveguide device 101, the core unit 12 is branched in the core units 12a and 12b by the branching circuit 12c, the VCSEL 15a is connected to the core unit 12a, and the PD 15b is connected to the core unit 12b. Therefore, the optic communication can be carried out in both directions by one core unit 12. Further, the core unit 12 comprises a known optical filter which uses the bragg reflection or the like, and the core unit 12 may have a structure in which the WDM (Wavelength Division Multiplexing) is carried out.

Moreover, the metal wiring 14 may have a structure of being formed on the other surface (surface in the direction of Z2 in the example shown in the drawing) of the film substrate 11 as shown in FIG. 5A other than having a structure of being formed on the clad unit 13. In this case, the metal wiring 14 and the photoelectric conversion element 15 are connected by the solder bump 17 via the Via as shown in FIG. 5A.

Similarly, the photoelectric conversion element 15 may have a structure of being provided on the other surface (surface in the direction of Z2 in the example shown in the drawing) of the film substrate 11 as shown in FIG. 5B. In this case, although it is not shown in the drawing, the metal wiring 14 formed on the clad unit 13 and the photoelectric conversion element 15 provided on the other surface of the film substrate 11 may be connected by the Via.

As described above, the optical waveguide device 100 has a structure in which the core unit 12 and the optical cable constituted of the clad unit 13 are extended on the film substrate 11, the photoelectric conversion element 15 optically coupled with the core unit 12 is provided, and the metal wiring 14 electrically connected to the photoelectric conversion element 15 is extended towards the end of the light guide direction.

Therefore, the optical waveguide device 100 can easily carry out the assembly by being connected with an apparatus at the end of the light guide direction only by the conventional metal wiring 14, and the optical communication can be carried out without necessarily carrying out the alignment between the photoelectric conversion element 15 and the core unit 12. Thus, an easy and a low cost optical communication between the apparatuses can be realized.

Moreover, in the optical waveguide device 100, the surface on which the photoelectric conversion element 15 and the metal wiring 14 are to be provided may be the clad unit 13 formed on the film substrate 11 or either surface of the film substrate 11. Therefore, the optical waveguide device 100 can be laid out freely.

In the optical waveguide device 100, the end mirror 16 which reflects the light in the traversing direction of the optic guide direction of the core unit 12 is formed. Therefore, there is no need to face the light receiving/emitting surface of the photoelectric conversion element 15 in the optic guide direction and mounting of the photoelectric conversion element 15 can be carried out easily on the film.

In the optical waveguide device 100, the end mirror 16 is an inclined surface which is exposed outside by being inclined in the traversing direction. Therefore, the optical waveguide device 100 can be manufactured easily by the work by the dicing saw or the like.

In the optical waveguide device 100, the photoelectric conversion element 15 and the metal wiring 14 are respectively provided at the end of the light guide direction by the optical waveguide device 100. Therefore, the connection between both substrates can be carried out easily by an electrical connection via the conventional connector or the like.

In the optical waveguide device 100, the branching circuit 12c is disposed in the middle of the core unit 12 and the core unit 12 is branched by the branching circuit 12c.
Therefore, the optical waveguide device 100 can carry out the sending and receiving by one core unit 12.

In the optical waveguide device 100, the metal wiring 14 extends across between both ends of the light guide direction on the outside surface of the film substrate 11 and/or the clad member 13. Therefore, a normal electrical communication can be carried out between apparatuses which are connected at both ends.

In the optical waveguide device 100, the clad unit 13 and the core unit 12 are formed in a film form on the film substrate 11. Therefore, the optical waveguide device 100 can be managed freely.

In the optical waveguide device 100, the photoelectric conversion element 15 is mounted by the flip-chip connection. Therefore, an excessive space for a wire is not taken.

### Industrial Application

The optical waveguide device of the present invention can be used in the field of optical communication. Description of reference numerals

- 100, 101: optical waveguide device
- 11: film substrate
- 12, 12a, 12b: core unit
- 13: clad unit
- 13a: lower clad unit
- 13b: upper clad unit
- 14, 141 to 146: metal wiring
- 15: photoelectric conversion element
- 15a: VCSEL
- 15b: PD
- 16: end mirror
- 17: solder bump
- 21: substrate
- 22: connection connector
- A: area
- L1, L2: width

## Claims

1. An optical waveguide device, wherein
an optic cable which is constituted of a clad unit and a core unit provided therein extends on a film substrate in a light guide direction,
a photoelectric conversion element which optically couples with the core unit is mounted on the film substrate, and a metal wiring which is electrically connected to the photoelectric conversion element extends toward ends of the light guide direction of the film substrate.

2. The optical waveguide device as claimed in claim 1, wherein the photoelectric conversion element is mounted on a surface of the film substrate which is same side as a surface in which the optic cable is extended on the film substrate.

3. The optical waveguide device as claimed in claim 1, wherein the photoelectric conversion element is mounted on a surface of the film substrate which is opposite side of a surface in which the optic cable is extended on the film substrate and the optic cable and the core unit are optically coupled via the film substrate.

4. The optical waveguide device as claimed in any one of claims 1 to 3, wherein the metal wiring is extended on the surface of the film substrate which is same side as the surface in which the optic cable is extended on the film substrate.

5. The optical waveguide device as claimed in any one of claims 1 to 3, wherein
the metal wiring is extended on the surface of the film substrate which is opposite side of the surface in which the optic cable is extended on the film substrate.

6. The optical waveguide device as claimed in any one of claims 1 to 5, wherein an end mirror which reflects a light in a traversing direction of the light guide direction of the core unit is formed at an optical coupling portion in which the core unit couples with the photoelectric conversion element.

7. The optical waveguide device as claimed in claim 6, wherein the end mirror is formed on an end surface of the core unit so as to incline with respect to a cross-sectional surface of the light guide direction and is an inclining surface which is exposed outside of the clad unit.

8. The optical waveguide device as claimed in any one of claims 1 to 7, wherein the photoelectric conversion element and the metal wiring are provided at each end of the light guide direction of the film substrate.

9. The optical waveguide device as claimed in claim 8, wherein the photoelectric conversion element at one end of the light guide direction of the film substrate is a light emitting element and the photoelectric conversion element at the other end is a light receiving element.

10. The optical waveguide device as claimed in any one of claims 1 to 9, wherein the core unit is branched via a branching circuit, the photoelectric conversion elements are optically coupled with each of the branched core units, and the metal wiring is applied to each of the photoelectric conversion elements.

11. The optical waveguide device as claimed in any one of claims 1 to 10, wherein the metal wiring which extends across between both ends of the light guide direction of the film substrate is provided on an outside surface of the film substrate and/or an outside surface of the clad unit.

12. The optical waveguide device as claimed in any one of claims 1 to 11, wherein the optic cable is formed in a film form.

13. The optical waveguide device as claimed in any one of claims 1 to 12, wherein the photoelectric conversion element is mounted by a flip-chip connection.
